**Europäisches Patentamt**

**European Patent Office**

**Office européen des brevets**

(19)

(11) Veröffentlichungsnummer: **0 021 185**
**B1**

(12) **EUROPÄISCHE PATENTSCHRIFT**

(45) Veröffentlichungstag der Patentschrift: **01.06.83**

(21) Anmeldenummer: **80103151.9**

(22) Anmeldetag: **06.06.80**

(51) Int. Cl.³: **H 01 L 45/00, H 03 K 4/787**

(54) **Dünnfilm-Dioden-Anordnung.**

(30) Priorität: **03.07.79 DE 2926802**

(43) Veröffentlichungstag der Anmeldung:
**07.01.81 Patentblatt 81/1**

(45) Bekanntmachung des Hinweises auf die Patenterteilung:
**01.06.83 Patentblatt 83/22**

(84) Benannte Vertragsstaaten:
**FR GB NL**

(56) Entgegenhaltungen:
**FR - A - 2 031 421**
**US - A - 3 648 122**

(73) Patentinhaber: **Licentia Patent-Verwaltungs-GmbH**
**Theodor-Stern-Kai 1**
**D-6000 Frankfurt/Main 70 (DE)**

(72) Erfinder: **Dahlberg, Reinhard, Dr.**
**Innere Bergstrasse 32**
**D-7101 Flein (DE)**

(74) Vertreter: **Maute, Hans-Jürgen, Dipl.-Ing. et al,**
**Theodor-Stern-Kai 1**
**D-6000 Frankfurt/Main 70 (DE)**

Courier Press, Leamington Spa, England.

Dünnfilm-Dioden-Anordnung

Die Erfindung beschreibt eine Dünnfilm-Dioden-Anordnung, bei welcher mehrere kleinflächige Dünnfilm-Dioden zu einem mechanisch stabilen Bauelement integriert sind.

Dünnfilm-Dioden als elektronische Schaltelemente werden schon seit langem mit Oxydfilmen, Nitridfilmen, Chalkogenidfilmen, hochohmigen Halbleiterfilmen, organischen Filmen u.a. hergestellt. Bekannt sind auch Schaltelemente mit amorphen oder glasartigen Halbleiterfilmen. Ein Nachteil aller dieser Dünnfilm-Schalter besteht darin, daß die rein elektronischen Effekte von den begleitenden thermischen Effekten nicht getrennt werden können. Für die Gleichrichtung von Infrarot-Strahlung werden bevorzugt Dünnfilm-Dioden in Form von Metall-Whisker-Dioden oder von Metall-Punkt-Kontakt-Dioden (MIM=Metall Isolator Metall oder MOM=Metall Oxyd Metall) verwendet. Bei diesen Dioden wird eine feine Spitze von z.B. Wolfram auf eine Nickelplatte mit einer sehr dünnen Oxydschicht aufgesetzt. Es ist umstritten, ob die Oxydschicht dabei wesentlich ist oder ob diese Dioden auch ohne Oxydschicht über den Effekt einer thermischen Feldemission arbeiten.

Der Nachteil dieser MOM- und MIM-Dioden besteht in ihrer mechanischen Instabilität und geringen Reproduzierbarkeit.

Der Erfindung liegt die Aufgabe zugrunde, eine Dünnfilm-Dioden-Anordnung anzugeben, bei welcher die elektronischen von den thermischen Effekten getrennt werden können, und welche auch als stabile MOM- und MIM-Dioden-Anordnung für Infrarot-Anwendungen ausgebildet werden kann.

Diese Aufgabe wird erfindungsgemäß dadurch gelöst, daß zwei getrennte elektrisch leitende Körper vorgesehen sind, daß diese beiden Körper unter geringem mechanischem Druck mindestens drei definierte Berührungsstellen miteinander haben, daß ein Dünnfilm aus hochohmigem Halbleiter- oder Isolator-Material sich als Zwischenschicht an den Berührungsstellen der beiden Körper befindet, und daß die Fläche jeder Berührungsstelle kleiner als $1 \cdot 10^{-4}$ cm$^2$ ist.

Vorzugsweise ist die Fläche aller Berührungsstellen gleich groß. Durch die Minimalbedingung der Drei-Punkt-Auflage ist die mechanische Stabilität gewährleistet. Die elektrisch leitenden Körper können aus Metall, einer Legierung, aus einer metallisch leitenden Verbindung oder auch aus einem hochdotierten Halbleiter bestehen.

Bei einem bevorzugten Ausführungsbeispiel der Erfindung haben die beiden elektrisch leitenden Körper die Form von planparallelen Platten oder Scheiben. Jede Platte oder Scheibe hat auf einer ihrer Seiten eine Struktur von parallelen Wällen. Die Struktur auf mindestens einer Platte oder Scheibe ist mit einem Dünnfilm aus hochohmigen Halbleiter- oder Isolator-Material überzogen. Beide Platten oder Scheiben sind mit ihren strukturierten Oberflächenseiten unter definiertem leichtem mechanischem Druck so zusammengesetzt, daß die sich kreuzenden Wälle beider Platten oder Scheiben eine Vielzahl elektrisch parallel geschalteter Druck-Kontakte miteinander bilden, zwischen denen sich der Dünnfilm befindet.

Das Prinzip der gekreuzten, parallelen Wälle ist bereits in der deutschen Offenlegungsschrift DE—A—25 47 262 beschrieben worden. In der DE—A—25 47 262 wird jedoch die Anwendung auf eine Dünnfilm-Dioden-Anordnung nicht erwähnt.

Um den Dünnfilm beim Zusammenpressen der beiden Platten so wenig wie möglich zu beschädigen, werden die beiden Platten oder Scheiben vorzugsweise zunächst vor dem Aufbringen des Dünnfilmes mit ihren Struktur-seiten unter etwas größerem mechanischem Druck zusammengesetzt. Dadurch entstehen an den sich kreuzenden und berührenden Wällen Engewiderstände. Vorhandene Unebenheiten der Struktur werden durch geringfügige plastische Deformationen der Wälle ausgeglichen. Danach werden die beiden Platten oder Scheiben getrennt und der Dünnfilm auf mindestens eine Struktur aufgebracht. Unter geringerem Druck als vorher oder unter Verwendung einer isolierenden Folie oder Schicht am Rande der beiden Platten oder Scheiben, welche einen definierten Abstand erzwingt, werden die beiden Platten oder Scheiben in genau der gleichen Position zueinander—wie beim ersten Zusammendrücken—(ohne den Dünnfilm) wieder zusammengesetzt.

Als Material für den Dünnfilm lassen sich chemische Oberflächenschichten des Materials der elektrisch gut leitenden Körper, anodische Oxyde, thermische Oxyde, Nitride, Chalkogenide usw. verwenden. Die Dünnfilme können auch durch Aufdampfen in Vakuum, durch Hochfrequenz-Zerstäubung, durch pyrolythische- oder Gas-Entladungs-Abscheidung in an sich bekannter Weise aufgebracht sein.

Auch amorphe Halbleiter und Chalkogenid-Gläser können als Dünnfilm benutzt sein. Selbst organische Filme, wie z.B. Lipid- oder organische Halbleiter- und Farbstoff-Filme können verwendet werden.

Beim Betrieb der Dünnfilm-Anordnung mit Erwärmung der Dünnschicht kann auch Heiß-Leiter-Material, wie z.B. CuO, Mg-Ti-Spinell u.a. verwendet werden.

Die elektrisch parallel geschalteten Punkt-Kontakte in der Dünnfilm-Dioden-Anordnung der Erfindung stellen eine Struktur dar, in welcher die gleichen extrem guten Wärmeableitungsverhältnisse herrschen wie in einem Engewiderstand. Der Wärmewiderstand $W_K$

eines einzelnen Kontaktes der Dünnfilm-Dioden-Anordnung kann durch die Ungleichung

$$W_K < \frac{1}{\lambda_s \cdot 2D}$$

betrieben werden. Dabei ist $\lambda_s$ die spezifische Wärmeleitfähigkeit des Dünnfilm-Materials und 2D ist der Durchmesser des Engewiderstandes (das Gleichheitszeichen hinter $W_K$ würde für einen gleichgroßen Kontakt gelten, der ganz aus dem Material des Dünnfilmes besteht). Der elektrische Widerstand $R_K$ dieses Kontaktes ist bekanntlich durch die Beziehung gegeben

$$R_K = \frac{\rho}{2D} + \rho_s \frac{d}{\pi_D 2}.$$

Dabei ist $\rho$ der spez. elektrische Widerstand des Materials der elektrisch leitenden Körper, $\rho_s$ der spez. elektrische Widerstand des Dünnfilm-Materials und d die Dicke des Dünnfilms.

Nimmt man einmal an, daß $\rho = 10^{-5}$ $\Omega$cm (Metall), $\rho_s = 10^4$ $\Omega$cm, $d = 5 \cdot 10^{-6}$ cm und $D = 1 \cdot 10^{-4}$ cm ist, dann wird der elektrische Widerstand eines Kontaktes $R_K = 5 \cdot 10^{-2} + 1 \cdot 10^6$ Ohm. Nimmt man weiter an, daß drei derartige Kontakte in einer Dünnfilm-Dioden-Anordnung parallel geschaltet sind, dann ist deren Gesamtwiderstand $3,3 \cdot 10^5$ Ohm. Legt man über einen Vorwiderstand von $1 \cdot 10^5$ Ohm eine Spannung von 430 Volt an die Dünnfilm-Dioden-Anordnung, dann liegt kurzzeitig eine Spannung von 330 Volt an den Dünnfilmen. Mit einer Dielektrizitätskonstante von 10 liegt damit ein elektrisches Feld

$$|f| \approx \frac{330}{10.5 \cdot 10^{-6}} \approx 6 \cdot 10^6 \text{ Volt/cm}$$

an den Dünnfilmen, welches größer als die Durchbruchsfeldstärke ist. Als Folge davon wird der elektrische Widerstand der Dünnfilme vernachlässigbar klein, und es fließt ein Strom $I^x$ von 4,3 mA durch die Anordnung, der durch den Vorwiderstand von $10^5$ Ohm bestimmt ist. Nimmt man einmal an, daß der spez. Widerstand $\rho_s$ von $10^4$ $\Omega$cm kurzzeitig bis auf $1 \cdot 10^{-3}$ $\Omega$cm zusammenbricht (was vermutlich nicht ganz erreicht wird), dann geht der elektrische Widerstand

$$R_K \rightarrow R_K^x \text{ von } 3,3 \cdot 10^5 \rightarrow 3,3 \cdot 10^{-2}$$

Ohm im Durchbruchsfall. Der Spannungsabfall an $R_K^x$ geht von $U = 330$ Volt auf

$$U_K^x = R_K^x \cdot I^x = 0,00014 \text{ Volt.}$$

Die Temperaturerhöhung $\Delta T$ in einem Kontakt (ohne Fremdschicht) als Folge einer angelegten Spannung U ist bekanntlich in erster Näherung gegeben durch

$$\Delta T = \frac{U^2}{8\rho\lambda}.$$

Wenn man fordert, daß die Temperaturerhöhung $\Delta T$ nur 10 Grad betragen soll (thermische Effekte also vernachlässigbar), dann läßt sich daraus die maximale Spannung $U_m$ für diese Voraussetzung ausrechnen. Setzt man noch für

$$\lambda = \lambda_s = 0,01 \left[\frac{\text{Watt} \cdot \text{cm}}{\text{grid}}\right]$$

(Dünnschicht-Material) und für $\rho = \rho_s^x = 10^{-3}$ $\Omega$cm dann wird $U_m \approx 0,028$ Volt. Diese "zulässige" Spannung am Kontakt ist etwa um den Faktor 200 höher als die oben ausgerechneten 0,00014 V für $U^x$ an den Dünnschichten im Durchbruch (die Gleichsetzung von $\lambda$ mit $\lambda_s$ und $\rho$ mit $\rho_s^x$ ist in Wirklichkeit eine sehr ungünstige Abschätzung). Dieses Ergebnis bedeutet, daß selbst für den Fall, daß von den drei Kontakten in der Dünnfilm-Dioden-Anordnung zwei aus irgendwelchen Gründen ausfallen sollten, der verbleibende einzelne Kontakt auch nur eine Erwärmung von weit unter 10° im Durchbruch erfahren würde. Für diesen Betriebsfall sind also thermische Effekte vernachlässigbar. Die Frage, ob rein elektrische Effekte oder thermische Effekte dominieren, wird damit über die Größe des Vorwiderstandes frei wählbar.

Die Anordnungen gemäß der Erfindung lassen sich deshalb als rein elektronische Schalter ausbilden.

Mit einem Dünnfilm mit negativem Temperaturkoeffizienten läßt sich die Anordnung jedoch auch als schneller Schalter ausbilden, der über thermische Effekte arbeitet.

Auch als Heißleiter mit sehr kleiner Abkühlzeit läßt sich die Anordnung unter Verwendung von Dünnfilmen aus Heißleiter-Material, wie z.B. Cu oder Mg-Ti-Spinell, verwenden.

Ebenso ist eine Verwendung als nichtthermischer und thermischer Sägezahngenerator möglich.

Wegen der Druckempfindlichkeit des elektrischen Widerstandes der Dünnfilm-Kontakte kann die Dünnfilm-Dioden-Anordnung auch als Druck-Sensor und Mikrophon ausgebildet werden.

Im folgenden soll die Erfindung in 5 Ausführungsbeispielen näher beschrieben werden.

Ausführungsbeispiel 1 beschreibt eine Dünnfilm-Dioden-Anordnung der Erfindung mit einem Chalkogenid-Glas als Dünnfilm.

Ausführungsbeispiel 2 beschreibt eine MIM-Dioden-Anordnung der Erfindung für Infrarot-Anwendung.

Ausführungsbeispiel 3 beschreibt einen nichtthermischen Sägezahngenerator.

Ausführungsbeispiel 4 beschreibt einen thermischen Sägezahngenerator.

Ausführungsbeispiel 5 beschreibt einen mechanischen Druck-Sensor gemäß der Erfindung.

Ausführungsbeispiel 1

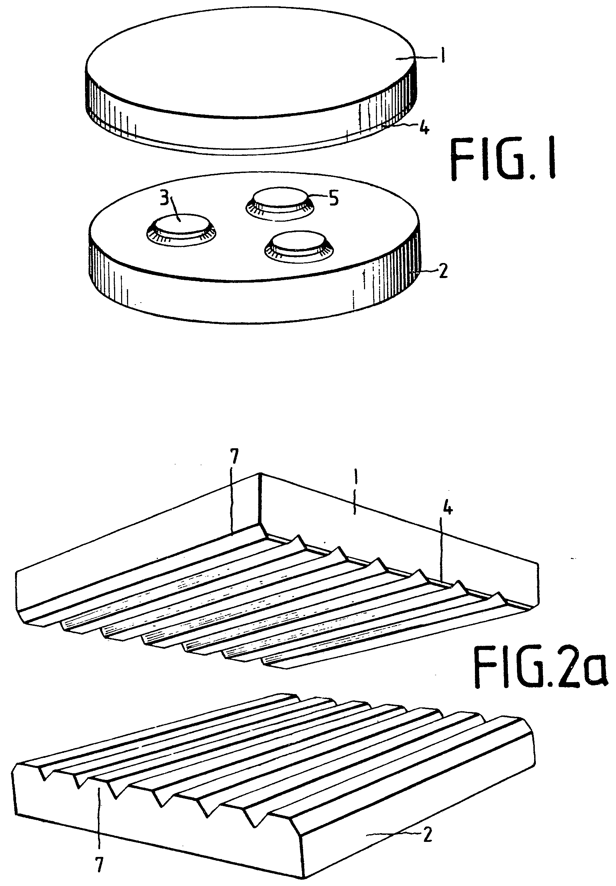

In Fig. 1 sind 1 und 2 zwei Nickelscheiben, die beim Aufeinanderlegen drei durch mesaförmige oder kegelstumpfförmige Erhebungen auf der Scheibe 2 definierte Berührungsstellen 3 haben. Die Berührungsstellen 3 sind mit einer $2 \cdot 10^{-7}$ dm dicken $SiO_2$-Schicht 5 überzogen. Die Nickelplatte 1 trägt auf ihrer den Erhebungen auf der Scheibe 2 zugewandten Unterseite eine $2 \cdot 10^{-4}$ cm dicke Sicht 4 aus $Ge_{10}As_{40}Te_{50}$-Glas.

Ausführungsbeispiel 2

In Fig. 2a ist 1 eine Nickelplatte, welche auf einer Seite eine Struktur mit sich verjüngenden parallel zueinander verlaufenden Wällen 7 trägt, die an ihrer Stirnfläche eine Breite von $2 \cdot 10^{-5}$ cm aufweisen. Die Wälle 7 tragen auf der Stirnseite eine NiO-Schicht 4 mit einer Dicke von $3 \cdot 10^{-7}$ cm.

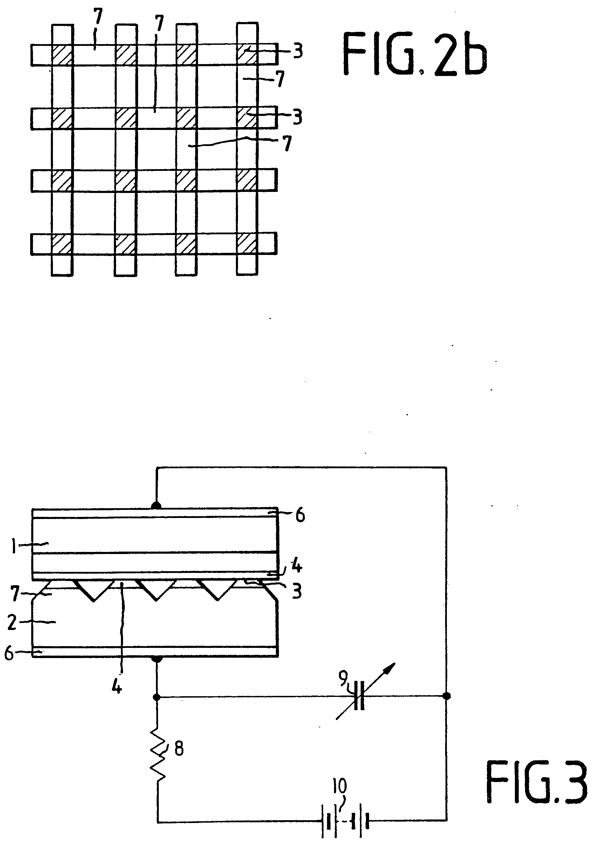

Die andere Platte 2 besteht aus Wolfram. Sie trägt einseitig die gleiche Struktur mit sich verjüngenden parallel zueinander verlaufenden Wällen wie die Nickelplatte 1. Beide Platten 1 und 2 werden—wie dies dargestellt istbezüglich der Wallstrukturen um 90° gegeneinander verdreht, aufeinander gelegt und mit definiertem mechanischen Druck belastet. Die sich überkreuzenden und berührenden Wälle 7 beider Platten 1 und 2 bilden dabei mit ihren Berührungsstellen eine flächenhafte Verteilung elektrisch parallel geschalteter MIM-Kontakte 3 zwischen den Platten 1 und 2. Die flächenhafte Verteilung dieser MIM-Kontakte 3 zeigt Fig. 2b in einer schematischen Darstellung der Berührungsebene.

Ausführungsbeispiel 3

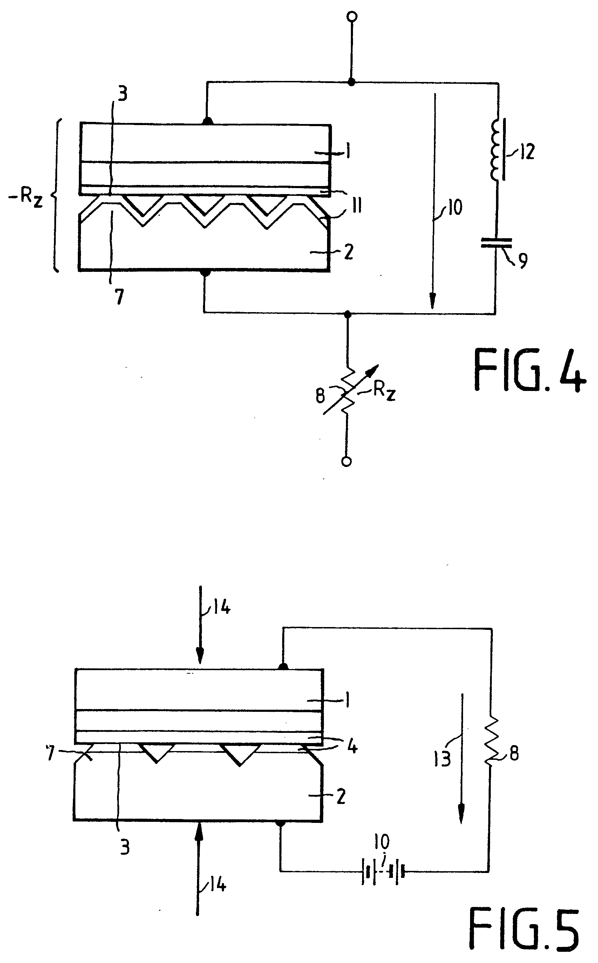

In Fig. 3 sind 1 und 2 zwei n+-Siliziumscheiben, die auf jeweils einer Seite eine Struktur mit parallel zueinander verlaufenden und sich verjüngenden Wällen 7 tragen, welche an der Stirnseite mit einer Restbreite von $2 \cdot 10^{-4}$ cm enden. Die Strukturen beider Scheiben 1 und 2 sind mit einer $2 \cdot 10^{-6}$ cm dicken thermisch erzeugten $SiO_2$-Schicht 4 überzogen. 6 sind sperrfreie Kontakte an den beiden Siliziumscheiben 1 und 2 auf den den Wallstrukturen gegenüber liegenden Oberflächenseiten. Die Scheiben 1 und 2 werden mit ihren strukturierten und bezüglich ihrer Strukturen um 90° gegeneinander verdrehten Oberflächenseiten unter Druck zusammengesetzt. Die sich kreuzenden Wälle 7 bilden sechzehn elektrisch parallel geschaltete Dünnfilm-Dioden mit einem Gesamtwiderstand von ca. $10^{12}$ Ohm. Über den Vorwiderstand 8 mit 20 Kilo-Ohm liegt die Gleichspannung 10 von ca. 200 Volt an den sperrfreien Kontakten 6 der beiden Scheiben 1 und 2. 9 ist ein parallel zur Dioden-anordnung geschalteter Kondensator, über den die Frequenz der Sägezahnschwingungen variiert werden kann.

Ausführungsbeispiel 4

In Fig. 4 sind 1 und 2 Kupfer-Scheiben, die einseitig eine Struktur parallel zueinander verlaufender und sich zur Stirnseite hin verjüngender Wälle 7 aufweisen. Die kleinste Breite der Wälle beträgt an der Stirnseite $1 \cdot 10^{-3}$ cm. Die Kupfer-Scheiben 1 und 2 sind nach dem Erzeugen der Wälle 7 zumindest auf den strukturierten Oberflächen mit je einer $1 \cdot 10^{-3}$ cm dicken Schicht 11 aus CuO überzogen worden. Durch Zusammensetzen beider, bezüglich der Wallstrukturen um 90° gegeneinander verdrehter Scheiben 1 und 2 sind an den Berührungsstellen der sich kreuzenden Wälle sechzehn Dünnfilm-Dioden 3 mit einem Gesamtwiderstand von ca. $10^8$ Ohm entstanden. Die beiden Scheiben 1 und 2 sind elektrisch in Serie zum Reihen-Schwingkreis aus der Induktivität 12 und der Kapazität 9 geschaltet. In Reihe zu dieser Schaltung, an der die maximale Spannung 10 von 1.000 Volt anliegt, ist der elektrische Widerstand 8 geschaltet, dessen Größe ($R_z$=10 Kilo-Ohm) dem Betrage nach die gleiche Größe aufweist, wie der differentielle Widerstand $R_z$ der Dünnfilm-Dioden-Anordnung mit dem CuO-Dünnfilm 11.

Ausführungsbeispiel 5

In Fig. 5 sind 1 und 2 Scheiben aus pyrolytischem Graphit, welche einseitig jeweils eine Struktur parallel zueinander verlaufender Wälle 7 tragen, die sich verjüngen und stirnseitig mit einem Krümmungsradius von $1 \cdot 10^{-3}$ cm enden. Auf die Strukturen beider Scheiben 1 und 2 ist eine $Al_2O_3$-Schicht 4 mit einer Dicke von $5 \cdot 10^{-6}$ cm durch Hochfrequenz-Kathoden-Zerstäubung aufgebracht. Beide Scheiben 1 und 2 sind bezüglich der Wallstrukturen um ca. 90° gegeneinander verdreht zusammengedrückt und fixiert. Über den Widerstand 8 liegt die elektrische Spannung 10 an den beiden Scheiben 1 und 2 an. Durch den mechanischen Druck 14 wird der Widerstand der Dünnfilm-Kontakte 3 und damit der elektrische Strom 13 durch den Widerstand 8 beeinflußt.

Bezugsziffern

| | |
|---|---|
| 1 | elektrisch leitender Körper 1 |
| 2 | elektrisch leitender Körper 2 |
| 3 | Berührungsstelle zwischen 1 und 2 |
| 4 | hochohmiger Dünnfilm |
| 5 | Schicht aus glasartigem Halbleiter |
| 6 | sperrfreier Kontakt |
| 7 | Wall |
| 8 | elektrischer Widerstand |
| 9 | elektrischer Kondensator |
| 10 | elektrische Spannung |
| 11 | Heißleiter-Schicht |
| 12 | Induktivität |
| 13 | elektrischer Strom |
| 14 | mechanischer Druck |

## Patentansprüche

1. Dünnfilm-Dioden-Anordnung, dadurch gekennzeichnet, daß zwei getrennte elektrisch leitende Körper (1, 2) vorgesehen sind, daß diese beiden Körper (1, 2) unter mechanischem Druck mindestens drei definierte Berührungsstellen (3) miteinander haben, daß ein Dünnfilm (4) aus hochohmigem Halbleiter- oder Isolator-Material sich als Zwischenschicht an den Berührungsstellen (3) der beiden Körper (1, 2) befindet und daß die Fläche jeder Berührungsstelle (3) kleiner als $1 \cdot 10^{-4}$ cm$^2$ ist.

2. Dünnfilm-Dioden-Anordnung nach Anspruch 1, dadurch gekennzeichnet, daß die Berührungsstellen (3) flächengleich sind.

3. Dünnfilm-Dioden-Anordnung nach einem der vorhergehenden Ansprüche, dadurch gekennzeichnet, daß die elektrisch leitenden Körper (1, 2) aus Metall, einer Legierung, aus einer metallisch leitenden Verbindung oder aus einem hochdotierten Halbleiter bestehen.

4. Dünnfilm-Dioden-Anordnung nach einem der vorhergehenden Ansprüche, dadurch gekennzeichnet, daß die elektrisch gut leitenden Körper (1, 2) die Form von planparallelen Platten oder Scheiben haben, daß jede Platte oder Scheibe auf einer Seite einer Struktur von parallel zueinander verlaufenden Wällen (7) aufweist, deren Oberfläche mindestens bei einer Platte oder Scheibe mit einem Dünnfilm (4) aus hochohmigem Halbleiter- oder Isolator-Material überzogen ist, und daß die beiden Platten oder Scheiben (1, 2) mit den Strukturen unter definiertem, leichtem mechanischem Druck so zusammengesetzt sind, daß die Wälle (7) beider Platten oder Scheiben eine Vielzahl elektrisch parallel geschalteter Druck-Kontakte (3) miteinander bilden, zwischen denen sich der Dünnfilm (4) befindet.

5. Dünnfilm-Dioden-Anordnung nach einem der vorhergehenden Ansprüche, dadurch gekennzeichnet, daß als Dünnfilm chemische Oberflächenschichten des Materials der elektrisch gut leitenden Körper (1, 2) vorgesehen sind, wie z.B. anodische Oxyde, thermische Oxyde, Nitride, Chalkogenide u.a.

6. Dünnfilm-Dioden-Anordnung nach einem der vorhergehenden Ansprüche, dadurch gekennzeichnet, daß als Dünnfilm amorphe Halbleiter oder Chalkogenid-Gläser vorgesehen sind.

7. Dünnfilm-Dioden-Anordnung nach einem der vorhergehenden Ansprüche, dadurch gekennzeichnet, daß als Dünnfilm organische Filme wie z.B. Farbstoff- oder Lipid-Filme vorgesehen sind.

8. Dünnfilm-Dioden-Anordnung nach einem der vorhergehenden Ansprüche, dadurch gekennzeichnet, daß als Dünnfilm ein Heißleiter-Material wie z.B. CuO oder Mg-Ti-Spinell vorgesehen ist.

9. Dünnfilm-Dioden-Anordnung nach einem der vorhergehenden Ansprüche, gekennzeichnet durch ihre Verwendung als nichtthermischer Schalter.

10. Dünnfilm-Dioden-Anordnung nach einem der vorhergehenden Ansprüche, gekennzeichnet durch ihre Verwendung für einen nichtthermischen Sägezahn-Oszillator.

11. Dünnfilm-Dioden-Anordnung nach einem der vorhergehenden Ansprüche, gekennzeichnet durch ihre Verwendung als Heißleiter mit kleiner thermischer Abkühlzeitkonstante.

12. Dünnfilm-Dioden-Anordnung nach einem der vorhergehenden Ansprüche, gekennzeichnet durch ihre Verwendung für einen thermischen Sägezahn-Generator.

13. Verfahren zum Herstellen einer Dünnfilm-Dioden-Anordnung nach einem der vorhergehenden Ansprüche, dadurch gekennzeichnet, daß zunächst ohne Vorhandensein eines Dünnfilmes (4) durch Zusammensetzen der beiden Platten oder Scheiben (1, 2) mit den Struktur-Seiten unter größerem mechanischem Druck eine Anordnung von elektrisch parallel geschalteten Engewiderständen erzeugt wird, daß danach die Platten wieder getrennt werden, daß dann der Dünnfilm (4) auf der Struktur-Seite einer oder beider Platten aufgebracht wird und daß danach die beiden Platten (1, 2) wieder mit ihren strukturierten Seiten unter geringerem Druck oder unter Verwendung einer Abstands-Folie oder einer Abstands-Schicht in genau der gleichen Position zueinander—wie beim ersten Zusammendrücken ohne den Dünnfilm—unter Bildung von Druck-Kontakten zusammengesetzt werden.

14. Verfahren nach einem der vorhergehenden Ansprüche, dadurch gekennzeichnet, daß die Dünnfilme durch Aufdampfen im Vakuum, durch Hochfrequenz-Zerstäubung oder durch chemische Abscheidung aufgebracht werden.

## Revendications

1. Dispositif à diode à couche mince, caractérisé en ce qu'il est composé de deux corps conducteurs électriques séparés (1, 2) qui sont appliqués par une faible pression mécanique l'un contre l'autre en au moins trois points de contact définis (3), avec interposition d'une couche mince (4) de matériau semi-conducteur ou isolant de résistance ohmique élevée aux points de contact (3) entre les deux corps (1, 2) et que l'aire de chaque point de contact (3) est plus petite que $1 \cdot 10^{-4}$ cm$^2$.

2. Dispositif selon la revendication 1, caractérisé en ce que les points de contact (3) possèdent la même aire de surface.

3. Dispositif selon l'une des revendications précédentes, caractérisé en ce que les corps conducteurs électriques (1, 2) sont faits d'un métal, d'un alliage, d'un composé à conduction métallique ou d'un semi-conducteur fortement dopé.

4. Dispositif selon l'une des revendications précédentes, caractérisé en ce que les corps bons conducteurs électriques (1, 2) affectent la forme de plaquettes ou de pastilles à faces parallèles, que chaque plaquette ou pastille présente d'un côté une structure de nervures parallèles (7), en particulier de nervures de section droite à peu près trapézoïdale, dont le dessus est recouvert d'une couche mince (4) de matériau semi-conducteur ou isolant sur au moins une plaquette ou pastille, et en ce que les deux plaquettes ou pastilles (1, 2) sont assemblées sous une pression mécanique légère définie avec leurs faces nervurées appliquées l'une contre l'autre et de manière que les nervures (7) se croisent, de sorte que les croisements des nervures (7) des deux plaquettes ou pastilles constituent autant de points de contact (3) par pression, qui sont branchés électriquement en parallele et dans lesquels est interposée la couche mince (4).

5. Dispositif selon l'une des revendications précédentes, caractérisé en ce que la couche mince est une couche de surface chimique du matériau constitutif des corps bons conducteurs électriques (1, 2), formée par exemple d'un oxyde anodique, d'un oxyde thermique, d'un nitrure, d'un chalcogénure ou d'une substance analogue.

6. Dispositif selon l'une des revendications précédentes, caractérisé en ce que la couche mince est formée par un semi-conducteur amorphe ou un verre de chalcogénure.

7. Dispositif selon l'une des revendications précédentes, caractérisé en ce que la couche mince est formée par une couche organique telle qu'une couche de colorant ou de lipide.

8. Dispositif selon l'une des revendications précédentes, caractérisé en ce que la couche mince est formée d'un matériau pour thermistances tel que CuO ou le spinell Mg-Ti.

9. Dispositif selon l'une des revendications précédentes, caractérisé par son application comme commutateur non thermique.

10. Dispositif selon l'une des revendications précédentes, caractérisé par son application pour un oscillateur à dents de scie non thermique.

11. Dispositif selon l'une des revendications précédentes, caractérisé par son application comme thermistance possédant une petite constante de temps de refroidissement.

12. Dispositif selon l'une des revendications précédentes, caractérisé par son application pour un générateur d'impulsions en dents de scie thermique.

13. Procédé pour fabriquer un dispositif à diode à couche mince selon l'une des revendications précédentes, caractérisé en ce que l'on produit d'abord, en l'absence d'une couche mince (4), par assemblage des deux plaquettes ou pastilles (1, 2) par leurs côtés structurés sous une forte pression mécanique, un dispositif de resistances de constriction branchées électriquement en parallèle, que l'on sépare ensuite les plaquettes puis que l'on applique la couche mince (4) sur le côté structuré de l'une ou des deux plaquettes et que l'on réassemble après cela les deux plaquettes (1, 2) avec leurs côtés structurés sous une pression plus faible, ou en utilisant une pellicule ou une couche d'espacement, exactement à la même position relative—que lors du premier pressage ensemble, sans la couche mince—en formant ainsi des contacts par pression.

14. Procédé selon l'une des revendications précédentes, caractérisé en ce que les couches minces sont appliquées par métallisation sous vide, par pulvérisation cathodique à haute fréquence ou par dépôt chimique.

**Claims**

1. Thin film diode arrangement, characterized in that two separate electrically conductive members (1, 2) are provided, in that these two members (1, 2) under mechanical pressure form at least three defined contact points (3) with one another, in that a thin film (4) of high-resistance semiconductor or insulator material is positioned as intermediate layer at the contact points (3) of the two members (1, 2), and in that the surface of each contact point (3) is smaller than $1. 10^{-4}$ cm².

2. Thin film diode arrangement as defined in claim 1, characterized in that the contact points (3) have the same surface area.

3. Thin film diode arrangement as defined in one of the preceding claims, characterized in that the electrically conductive members (1, 2) consist of metal, an alloy, a metallically conductive compound or a highly doped semiconductor.

4. Thin film diode arrangement as defined in one of the preceding claims, characterized in that the electrically good conductive members (1, 2) have the shape of plane-parallel plates or disks, in that each plate or disk comprises on one side a structure of walls (7) which extend parallel to one another and whose surface, at least in the case of one plate or disk, is covered with a thin film (4) of high-resistance semiconductor or insulator material, and in that the two plates or disks (1, 2) are so combined with the structures under a defined, slight mechanical pressure that the walls (7) of both plates or disks form with one another a plurality of electrically parallel connected pressure contacts (3), between which a thin film (4) is positioned.

5. Thin film diode arrangement as defined in one of the preceding claims, characterized in that chemical surface layers of the material of the electrically good conductive members (1, 2) such as, for example, anodic oxides, thermal oxides, nitrides, chalcogenides and others, are provided as thin film.

6. Thin film diode arrangement as defined in one of the preceding claims, characterized in that amorphous semiconductors or chalcogenide glasses are provided as thin film.

7. Thin film diode arrangement as defined in one of the preceding claims, characterized in that organic films such as, for example, dye films or lipid films are provided as thin film.

8. Thin film diode arrangement as defined in one of the preceding claims, characterized in that an NTC resistor material such as, for example, CuO or Mg-Ti-spinel is provided as thin film.

9. Thin film diode arrangement as defined in one of the preceding claims, characterized by its use as non-thermal switch.

10. Thin film diode arrangement as defined in one of the preceding claims, characterized by its use for a non-thermal sawtooth oscillator.

11. Thin film diode arrangement as defined in one of the preceding claims, characterized by its use as NTC resistor with a small thermal cooling time constant.

12. Thin film diode arrangement as defined in one of the preceding claims, characterized by its use for a thermal sawtooth generator.

13. Process for the manufacture of a thin film diode arrangement as defined in one of the preceding claims, characterized in that firstly, without the provision of a thin film (4), an arrangement of electrically parallel connected constriction resistors is produced by combining the two plates or disks (1, 2) at their structured sides under relatively high mechanical pressure, in that the plates are subsequently separated from one another again, in that the thin film (4) is then applied to the structured side of one or both of the plates, and in that the two plates (1, 2) are subsequently combined again at their structured sides under relatively low pressure or using a distance foil or a distance layer in exactly the same position relative to one another—as when first combined without the thin film—to form pressure contacts.

14. Process as defined in one of the preceding claims, characterized in that the thin films are applied by vacuum evaporation, high-frequency atomization or chemical depositing.

FIG.1

FIG.2a

FIG.2b

FIG.3

FIG.4

FIG.5